(19) Europäisches Patentamt
European Patent Office
Office européen des brevets

(11) **EP 3 624 343 B1**

(12) **FASCICULE DE BREVET EUROPEEN**

(45) Date de publication et mention de la délivrance du brevet:
**07.04.2021   Bulletin 2021/14**

(51) Int Cl.:
*H03L 7/083* *(2006.01)*      *H03L 7/24* *(2006.01)*

(21) Numéro de dépôt: **19197250.4**

(22) Date de dépôt: **13.09.2019**

(54) **DISPOSITIF DE REGLAGE DU VERROUILLAGE D'UN MULTIPLICATEUR DE FREQUENCE A VERROUILLAGE PAR INJECTION**

REGULIERUNGSVORRICHTUNG DER SPERRUNG EINES FREQUENZMULTIPLIKATORS MIT INJEKTIONSSPERRE

DEVICE FOR ADJUSTING THE LOCKING OF A FREQUENCY MULTIPLIER WITH LOCKING BY INJECTION

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **14.09.2018   FR 1858325**

(43) Date de publication de la demande:
**18.03.2020   Bulletin 2020/12**

(73) Titulaire: **Commissariat à l'énergie atomique et aux énergies alternatives**
**75015 Paris (FR)**

(72) Inventeurs:
• **Jany, Clément**
  **38054 GRENOBLE CEDEX 09 (FR)**
• **Gonzalez Jimenez, José-Luis**
  **38054 GRENOBLE CEDEX 09 (FR)**
• **Hameau, Frédéric**
  **38054 GRENOBLE CEDEX 09 (FR)**
• **Siligaris, Alexandre**
  **38054 GRENOBLE CEDEX 09 (FR)**

(74) Mandataire: **Brevalex**
**95, rue d'Amsterdam**
**75378 Paris Cedex 8 (FR)**

(56) Documents cités:
**CA-A1- 2 395 891**

• YAN CHENGGANG ET AL: "A 370[mu]W Ring VCO Based Injection-Locked Frequency Synthesizer for GPS Receiver", 2018 3RD INTERNATIONAL CONFERENCE ON COMPUTER AND COMMUNICATION SYSTEMS (ICCCS), IEEE, 27 avril 2018 (2018-04-27), pages 387-391, XP033402211, DOI: 10.1109/CCOMS.2018.8463333
• YOO SEYEON ET AL: "19.2 A PVT-robust -39dBc 1kHz-to-100MHz integrated-phase-noise 29GHz injection-locked frequency multiplier with a 600 W frequency-tracking loop using the averages of phase deviations for mm-band 5G transceivers", 2017 IEEE INTERNATIONAL SOLID-STATE CIRCUITS CONFERENCE (ISSCC), IEEE, 5 février 2017 (2017-02-05), pages 324-325, XP033073609, DOI: 10.1109/ISSCC.2017.7870392
• CHO SUNG-YONG ET AL: "A 2.5-5.6 GHz Subharmonically Injection-Locked All-Digital PLL With Dual-Edge Complementary Switched Injection", IEEE TRANSACTIONS ON CIRCUITS AND SYSTEMS I: REGULAR PAPERS, IEEE, US, vol. 65, no. 9, 1 septembre 2018 (2018-09-01), pages 2691-2702, XP011688018, ISSN: 1549-8328, DOI: 10.1109/TCSI.2018.2799195 [extrait le 2018-08-03]
• JANY CLEMENT ET AL: "A novel ultra-low phase noise, programmable frequency multiplier-by-30 architecture. Application to 60-GHz frequency generation", 2013 PROCEEDINGS OF THE ESSCIRC (ESSCIRC), IEEE, 22 septembre 2014 (2014-09-22), pages 427-430, XP032672110, ISSN: 1930-8833, DOI: 10.1109/ESSCIRC.2014.6942113 ISBN: 978-1-4799-0643-7 [extrait le 2014-10-31]

- **SIRIBURANON TEERACHOT ET AL: "A 2.2 GHz $-242\;\text{dB}$-FOM 4.2 mW ADC-PLL Using Digital Sub-Sampling Architecture", IEEE JOURNAL OF SOLID-STATE CIRCUITS, IEEE SERVICE CENTER, PISCATAWAY, NJ, USA, vol. 51, no. 6, 1 juin 2016 (2016-06-01), pages 1385-1397, XP011613878, ISSN: 0018-9200, DOI: 10.1109/JSSC.2016.2546304 [extrait le 2016-06-13]**

Remarques:
Le dossier contient des informations techniques présentées postérieurement au dépôt de la demande et ne figurant pas dans le présent fascicule.

**Description**

**DOMAINE TECHNIQUE ET ART ANTÉRIEUR**

Le domaine technique de l'invention est celui des dispositifs multiplicateurs de fréquence à verrouillage par injection, utilisés par exemple pour l'émission et/ou la réception de signaux, par exemple dans le domaine radiofréquence (RF). L'invention s'applique notamment aux systèmes d'émission et/ou réception de signaux dans lesquels une synthèse de fréquence est réalisée.

Un oscillateur verrouillé par injection, ou ILO pour « Injection-Locked Oscillator », est un oscillateur qui, en l'absence de signal d'injection appliqué en entrée, génère en sortie un signal à une fréquence d'oscillation propre, appelée fréquence d'auto-oscillation, qui dépend notamment de la valeur d'un signal de contrôle, appelé $V_{tune}$, appliqué sur une entrée de contrôle de l'ILO. Lorsqu'un signal d'injection est appliqué en entrée de l'ILO et que ce signal vérifie certaines conditions comme par exemple avoir une fréquence de valeur proche de celle de la fréquence d'auto-oscillation et un niveau d'amplitude suffisant, l'ILO se verrouille sur la fréquence du signal d'injection, ou un multiple de cette fréquence de sorte que sa fréquence d'oscillation soit dépendante de la fréquence sur laquelle l'ILO est verrouillé. L'ILO recopie les propriétés de phase du signal d'injection, notamment le bruit de phase.

L'utilisation d'un tel ILO permet d'éviter l'utilisation d'une boucle à verrouillage de phase, ou PLL pour « Phase-Locked Loop », pour générer un signal stabilisé en fréquence. De plus, l'ILO peut être utilisé pour former un multiplicateur de fréquence à verrouillage par injection, appelé dans ce cas ILFM (Injection-Locked Frequency Multiplier), ou un diviseur de fréquence à verrouillage par injection, appelé dans ce cas ILFD (Injection-Locked Frequency Divider).

Le document « A programmable Frequency Multiplier-by-29 Architecture for Millimeter Wave Applications » de C. Jany et al., IEEE Journal of Solid-State Circuits, n°99, pp. 1-11, juillet 2015, décrit un dispositif de synthèse de fréquence qui, pour générer un signal haute fréquence, réalise une multiplication entre un signal de plus basse fréquence et un signal périodique complexe centré à plus haute fréquence, puis réalise, à partir du résultat de cette multiplication de fréquence, une récupération de fréquence pour obtenir le signal haute fréquence souhaité. La récupération de fréquence est par exemple réalisée par un ILO.

Le verrouillage par injection réalisé dépend notamment des caractéristiques du signal d'injection appliqué en entrée de l'ILO qui force la valeur de la fréquence à laquelle oscille l'ILO. Le signal d'injection doit vérifier certaines conditions pour garantir le verrouillage de l'ILO, notamment des niveaux de puissance différents en fonction de la différence entre la fréquence du signal d'injection et la fréquence d'auto-oscillation de l'ILO. Pour un niveau de puissance donné du signal d'injection, il est possible de définir la plage de verrouillage de l'ILO comme étant la plage de fréquences du signal d'injection (ou d'un de ses multiples ou diviseurs dans le cas de l'ILFM ou ILFD, respectivement) qui se trouve autour de la valeur de la fréquence d'auto-oscillation de l'ILO et pour laquelle le verrouillage par injection est obtenu.

Des variations de certaines caractéristiques de l'ILO peuvent toutefois modifier la valeur de la fréquence d'auto-oscillation de l'ILO par rapport à sa valeur nominale, et décaler dans ce cas la plage de verrouillage par rapport à la fréquence nominale du signal d'injection. Afin de garantir le verrouillage par injection de l'ILO à la fréquence souhaitée, différentes techniques de réglage peuvent être utilisées pour modifier la fréquence d'auto-oscillation et recentrer la plage de verrouillage sur la fréquence nominale du signal d'injection. Ces techniques nécessitent de déterminer si l'ILO est bien verrouillé ou non sur le signal d'injection qui lui est appliqué en entrée. Pour cela, plusieurs solutions existent.

Il est par exemple possible d'extraire avec un « mixer », ou mélangeur, la différence entre la fréquence du signal d'injection, ou un multiple ou un diviseur de cette fréquence, et la fréquence d'auto-oscillation de l'ILO. Cette information peut alors être utilisée pour ajuster la fréquence d'auto-oscillation de l'ILO et réduire ainsi cette différence à zéro (dans le meilleur cas) ou à une valeur garantissant au moins que le signal d'injection se trouve dans la plage de verrouillage de l'ILO. Une telle solution est par exemple décrite dans le document « A Sub-Harmonic Injection-Locked Quadrature Frequency Synthesizer with Frequency Calibration Scheme for Millimeter-Wave TDD Transceivers » de W. Deng et al., IEEE J. Solid-State Circuits, vol.48 n°7, pp. 1710-1720, juillet 2013. Il est également possible d'utiliser un détecteur d'enveloppe pour extraire l'information relative à la différence entre la fréquence du signal d'injection, ou un multiple ou un diviseur de cette fréquence, et la fréquence d'auto-oscillation de l'ILO. Les documents "A Mixed-Mode Injection Frequency-Locked Loop for Self-Calibration of Injection Locking Range and Phase Noise in $0.13\mu m$ CMOS" de Dongseok Shin et al., ISSCC 2016, pp. 50-51, et "A Low-Integrated-Phase-Noise 27-30-GHz Injection-Locked Frequency Multiplier With an Ultra-Low-Power Frequency-Tracking Loop for mm-Wave-Band 5G Transceivers" de Seyeon Yoo, et al, IEEE Journal of Solid-StateE Circuits, Vol. 53, N°2, Février 2018, décrivent une telle technique.

Que la différence entre la fréquence du signal d'injection, ou un multiple ou un diviseur de cette fréquence, et la fréquence d'auto-oscillation de l'ILO soit obtenue en utilisant un mélangeur ou un détecteur d'enveloppe, ces deux dispositifs fonctionnent à haute fréquence, c'est-à-dire à la fréquence du signal de sortie de l'ILO qui fait par exemple partie de la bande mmW, ou bande de fréquences d'ondes millimétriques. Or, cela implique une forte consommation de puissance de ces dispositifs. De plus, de telles techniques ne sont pas adaptées dans le cas des ILFM lorsque le facteur de multiplication de fréquence entre celle du signal d'injection et celle du signal de sortie de l'ILO est important, par exemple supérieur à 3.

Une autre technique pour assurer le verrouillage de l'ILO en minimisant l'erreur de fréquence entre l'ILO et le signal d'injection appliqué en entrée consiste à asservir l'ILO dans une boucle de type PLL comprenant un comparateur de phases (« Phase Frequency Detector », or PFD) ou un comparateur de fréquences (« Frequency Detector, FD). Cette solution pose toutefois le même problème que celui rencontré avec un mélangeur ou un détecteur d'enveloppe fonctionnant à haute fréquence, à savoir une importante consommation d'énergie.

Une autre technique consiste à gérer le retard au sein d'un ILO réalisé sous la forme d'un oscillateur en anneau, par exemple avec des cellules de retard. Cette technique ne fonctionne toutefois pas pour des applications à haute fréquence.

Le document « A 370µW Ring VCO Based Injection-Locked Frequency Synthesizer for GPS Receiver» de Chenggang Yan et al., 2018 3RD INTERNATIONAL CONFERENCE ON COMPUTER AND COMMUNICATION SYSTEMS (ICCCS), IEEE, 27 avril 2018 (2018-04-27), pages 387-391, décrit un dispositif de synthèse de fréquence basé sur un oscillateur à verrouillage par injection incorporé dans une boucle à verrouillage de phase contenant un détecteur de phase de type sous-échantillonneur.

## J EXPOSÉ DE L'INVENTION

Un but de la présente invention est de proposer un dispositif de réglage du verrouillage d'un multiplicateur de fréquence à verrouillage par injection ne présentant pas les inconvénients de l'art antérieur exposés précédemment, c'est-à-dire qui soit peu consommateur d'énergie, utilisable pour des signaux de haute fréquence et lorsque le facteur de multiplication de fréquence est important.

Pour cela, il est proposé un dispositif de réglage configuré pour régler le verrouillage d'un multiplicateur de fréquence à verrouillage par injection, comprenant au moins :

- une première entrée configurée pour recevoir un premier signal de fréquence f1 destiné à être appliqué en entrée du multiplicateur de fréquence à verrouillage par injection, et une deuxième entrée configurée pour recevoir un deuxième signal de fréquence f2 destiné à être délivré en sortie du multiplicateur de fréquence à verrouillage par injection ;
- un sous-échantillonneur configuré pour réaliser un sous-échantillonnage du deuxième signal par le premier signal;
- un circuit de contrôle configuré pour :

  • recevoir en entrée un troisième signal obtenu en sortie du sous-échantillonneur et correspondant au deuxième signal sous-échantillonné par le premier signal, puis
  • déterminer que le multiplicateur de fréquence à verrouillage par injection est verrouillé sur une fréquence égale à un multiple de la fréquence f1 lorsque le troisième signal est continu et que le multiplicateur de fréquence à verrouillage par injection n'est pas verrouillé sur une fréquence égale à un multiple de la fréquence f1 lorsque le troisième signal varie dans le temps, puis
  • délivrer en sortie un quatrième signal dont la valeur est représentative du verrouillage ou non du multiplicateur de fréquence à verrouillage par injection sur une fréquence correspondant à un multiple de la fréquence f1.

Il est proposé en outre un dispositif de réglage configuré pour régler le verrouillage d'un multiplicateur de fréquence à verrouillage par injection, comprenant au moins :

- une première entrée configurée pour recevoir un premier signal de fréquence f1 destiné à être appliqué en entrée du multiplicateur de fréquence à verrouillage par injection, et une deuxième entrée configurée pour recevoir un deuxième signal de fréquence f2 destiné à être délivré en sortie du multiplicateur de fréquence à verrouillage par injection ;
- un sous-échantillonneur configuré pour réaliser un sous-échantillonnage du deuxième signal par le premier signal ou par un autre signal de fréquence $f_S$ égale à un multiple entier de la fréquence f1 et inférieure à la fréquence f2;
- un circuit de contrôle configuré pour :

  • recevoir en entrée un troisième signal obtenu en sortie du sous-échantillonneur et correspondant au deuxième signal sous-échantillonné par le premier signal ou par le signal de fréquence $f_S$, puis
  • déterminer que le multiplicateur de fréquence à verrouillage par injection est verrouillé sur une fréquence égale à un multiple de la fréquence f1 lorsque le troisième signal est continu et que le multiplicateur de fréquence à verrouillage par injection n'est pas verrouillé sur une fréquence égale à un multiple de la fréquence f1 lorsque le troisième signal varie dans le temps, puis
  • délivrer en sortie un quatrième signal dont la valeur est représentative du verrouillage ou non du multiplicateur de fréquence à verrouillage par injection sur une fréquence correspondant à un multiple de la fréquence f1 ;

- • et dans lequel le circuit de contrôle comporte un filtre intégrateur configuré pour réaliser un filtrage passe-haut ou passe-bande du troisième signal, le multiplicateur de fréquence à verrouillage par injection étant considéré comme verrouillé sur une fréquence correspondant à un multiple de la fréquence f1 lorsque le signal obtenu par ce filtrage passe-haut ou passe-bande est sensiblement nul.

Ce dispositif propose une solution alternative simplifiant la génération d'un signal (le quatrième signal) contenant une information sur la différence de fréquence entre l'entrée et la sortie du multiplicateur de fréquence, via un traitement peu consommateur d'énergie. Ce dispositif ne fait notamment pas appel à un diviseur de fréquence fonctionnant à haute fréquence qui est une source importante de consommation d'énergie.

Ce dispositif est de plus bien adapté pour fonctionner avec un multiplicateur de fréquence appliquant un important facteur de multiplication entre la fréquence du signal d'entrée et celle du signal de sortie, par exemple supérieur à 3, grâce au sous-échantillonnage réalisé.

Ce dispositif peut avantageusement faire partie d'un dispositif de synthèse de fréquence à basse consommation et à faible bruit de phase.

Avant que le verrouillage du multiplicateur de fréquence ne soit réglé, la valeur de la fréquence f2 peut être proche ou égale à celle d'un multiple de la fréquence f1.

Un signal est dit « continu » lorsque la valeur de son amplitude est sensiblement constante dans le temps, c'est-à-dire indépendante du temps.

Un signal est dit «variant dans le temps» lorsque la valeur de son amplitude change dans le temps, c'est-à-dire n'est pas sensiblement constante dans le temps.

Par exemple, le circuit de contrôle peut être configuré pour déterminer que le multiplicateur de fréquence à verrouillage par injection n'est pas verrouillé sur une fréquence correspondant à un multiple de la fréquence f1 lorsque le troisième signal est périodique. Un signal est dit « périodique » si les variations de son amplitude se reproduisent régulièrement au bout d'une période T constante.

Dans le domaine fréquentiel, la puissance d'un signal « continu » se trouve uniquement à la fréquence nulle, c'est-à-dire que seule la composante continue, ou DC, a une puissance non nulle. Un signal dit « variant dans le temps » ou « périodique » comporte de la puissance à des fréquences autres que la fréquence nulle. Cette différence de répartition de la puissance entre un signal continu et un signal variant dans le temps peut donc être utilisée pour déterminer si le multiplicateur de fréquence à verrouillage par injection est verrouillé ou non sur une fréquence correspondant à un multiple de la fréquence f1.

Le fait que la valeur du quatrième signal soit représentative du verrouillage ou non du multiplicateur de fréquence à verrouillage par injection sur une fréquence correspondant à un multiple de la fréquence f1 signifie qu'il est possible de déterminer, à partir de cette valeur, si le multiplicateur de fréquence à verrouillage par injection est verrouillé ou non sur une fréquence correspondant à un multiple de la fréquence f1.

Par exemple, le circuit de contrôle peut être configuré pour délivrer en sortie un quatrième signal dont l'amplitude a une première valeur lorsque le multiplicateur de fréquence à verrouillage par injection est verrouillé sur une fréquence correspondant à un multiple de la fréquence f1, et a une deuxième valeur, différente de la première valeur, lorsque le multiplicateur de fréquence à verrouillage par injection n'est pas verrouillé sur une fréquence correspondant à un multiple de la fréquence f1. Le quatrième signal peut dans ce cas correspondre à un signal fournissant une information sur l'état du verrouillage ou non du multiplicateur de fréquence sur une fréquence correspondant à un multiple de la fréquence f1. Ainsi, le dispositif de réglage peut servir de dispositif d'analyse, ou de dispositif d'information, du verrouillage d'un multiplicateur de fréquence à verrouillage par injection.

En variante, le quatrième signal peut être utilisé au sein d'une boucle de rétroaction pour servir de signal de rétroaction et amener le multiplicateur de fréquence à se verrouiller à un multiple de la fréquence f1. Dans ce cas, l'information que le multiplicateur de fréquence à verrouillage par injection est verrouillé sur une fréquence correspondant à un multiple de la fréquence f1 peut se déduire du fait que la valeur de l'amplitude du quatrième signal reste stable dans le temps, et l'information que le multiplicateur de fréquence à verrouillage par injection n'est pas verrouillé sur une fréquence correspondant à un multiple de la fréquence f1 peut se déduire du fait que la valeur de l'amplitude du quatrième signal n'est pas constante dans le temps, indiquant que le dispositif de réglage est encore dans une phase de réglage itératif du verrouillage du multiplicateur de fréquence.

De manière avantageuse, la sortie du circuit de contrôle peut être configurée pour être reliée à une entrée de contrôle du multiplicateur de fréquence à verrouillage par injection, le dispositif pouvant être dans ce cas configuré pour former une boucle de rétroaction permettant le verrouillage du multiplicateur de fréquence à verrouillage par injection sur une fréquence correspondant à un multiple de la fréquence f1. Le signal de sortie du circuit de contrôle peut notamment être utilisé pour modifier la fréquence d'auto-oscillation du multiplicateur de fréquence.

Le circuit de contrôle comporte un filtre intégrateur configuré pour réaliser un filtrage passe-haut ou passe-bande du troisième signal, le multiplicateur de fréquence à verrouillage par injection pouvant être considéré comme verrouillé sur une fréquence correspondant à un multiple de la fréquence f1 lorsque le signal obtenu par ce filtrage passe-haut ou passe-bande est sensiblement nul. La valeur de la fréquence de coupure basse du filtre intégrateur peut dépendre d'une caractéristique du signal d'injection reçu par le filtre intégrateur (c'est-à-dire le troisième signal), par exemple du bruit de phase du signal d'injection. A titre d'exemple, la fréquence de coupure basse du filtre intégrateur peut correspondre à la fréquence « offset » au-dessous de laquelle le bruit de phase du signal d'injection est majoritairement (par exemple au moins 50 %) contenu. Par exemple, pour un signal d'injection dans lequel au moins 66%, du bruit de phase est contenu dans une plage de fréquence dite « offset » allant jusqu'à une fréquence « offset » égale à environ 100 kHz, la fréquence de coupure basse du filtre intégrateur peut être égale à environ 100 kHz.

Le filtre intégrateur peut être configuré pour réaliser un filtrage passe-bande du troisième signal avec une fréquence de coupure haute égale à environ (fl)/2.

Le circuit de contrôle peut comporter en outre un comparateur configuré pour comparer un signal de sortie du filtre intégrateur avec une valeur seuil, et un système de contrôle configuré pour modifier ou non au moins un paramètre du multiplicateur de fréquence à verrouillage par injection en fonction d'une valeur d'un signal de sortie du comparateur.

L'invention porte également sur un dispositif de multiplication de fréquence, comprenant au moins :

- un multiplicateur de fréquence à verrouillage par injection ;
- un dispositif de réglage tel que défini ci-dessus, dont la deuxième entrée est couplée à une sortie du multiplicateur de fréquence à verrouillage par injection.

Le dispositif de réglage du verrouillage du multiplicateur de fréquence à verrouillage par injection peut être avantageusement utilisé lorsque le facteur de multiplication du multiplicateur de fréquence à verrouillage par injection est important, par exemple lorsque la valeur du rapport f2 / f1 est comprise entre environ 20 et 35, ou comprise entre environ 10 et 35.

Une entrée d'injection du multiplicateur de fréquence à verrouillage par injection peut être configurée pour recevoir le premier signal.

Le multiplicateur de fréquence à verrouillage par injection peut comporter au moins un oscillateur verrouillé par injection, ILO.

Dans un premier mode de réalisation, l'ILO peut assurer seul la fonction de multiplication de fréquence du multiplicateur de fréquence à verrouillage par injection, et former ainsi à lui seul un ILFM. Dans ce cas, une entrée d'injection de l'ILO peut être configurée pour recevoir le premier signal.

Dans un deuxième mode de réalisation, le multiplicateur de fréquence à verrouillage par injection peut comporter en outre un générateur de train d'oscillations répétées périodiquement configuré pour recevoir en entrée le premier signal et pour générer en sortie un cinquième signal correspondant à un train d'oscillations de fréquence sensiblement égale à N.fl, de durée inférieure à T1 = 1/f1 et répété périodiquement à la fréquence f1, avec N nombre entier supérieur à 1, et dont la sortie est couplée à l'entrée de l'ILO.

En outre, le dispositif peut être tel que :

- une entrée de contrôle de l'ILO est couplée à la sortie du circuit de contrôle ;
- le circuit de contrôle est configuré pour modifier la valeur du quatrième signal jusqu'à ce que le multiplicateur de fréquence à verrouillage par injection soit verrouillé sur une fréquence correspondant à un multiple de la fréquence f1.

Le dispositif de réglage forme dans ce cas une boucle de rétroaction dans laquelle se trouve le multiplicateur de fréquence à verrouillage par injection.

Il est également proposé un procédé de réglage du verrouillage d'un multiplicateur de fréquence à verrouillage par injection, comprenant au moins :

- génération, par le multiplicateur de fréquence à verrouillage par injection et à partir d'un premier signal de fréquence f1, d'un deuxième signal de fréquence f2 ;
- génération d'un troisième signal correspondant au deuxième signal sous-échantillonné par le premier signal;
- détermination que le multiplicateur de fréquence à verrouillage par injection est verrouillé sur une fréquence égale à un multiple de la fréquence f1 lorsque le troisième signal est continu et que le multiplicateur de fréquence à verrouillage par injection n'est pas verrouillé sur une fréquence égale à un multiple de la fréquence f1 lorsque le troisième signal varie dans le temps ;
- génération d'un quatrième signal dont la valeur est représentative du verrouillage ou non du multiplicateur de fréquence à verrouillage par injection sur une fréquence correspondant à un multiple de la fréquence f1.

Enfin, l'invention concerne également un procédé de réglage du verrouillage d'un multiplicateur de fréquence à verrouillage par injection, comprenant au moins :

- génération, par le multiplicateur de fréquence à verrouillage par injection et à partir d'un premier signal de fréquence f1, d'un deuxième signal de fréquence f2 ;
- génération d'un troisième signal correspondant au deuxième signal sous-échantillonné par le premier signal ou par un autre signal de fréquence $f_S$ égale à un multiple entier de la fréquence f1 et inférieure à la fréquence f2 ;
- filtrage passe-haut ou passe-bande du troisième signal ;
- détermination que le multiplicateur de fréquence à verrouillage par injection est verrouillé sur une fréquence égale à un multiple de la fréquence f1 lorsque le signal obtenu par ce filtrage passe-haut ou passe-bande est sensiblement nul ;
- génération d'un quatrième signal dont la valeur est représentative du verrouillage ou non du multiplicateur de fréquence à verrouillage par injection sur une fréquence correspondant à un multiple de la fréquence f1.

## BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :

- la figure 1 représente un dispositif de multiplication de fréquence comprenant un dispositif de réglage du verrouillage par injection d'un multiplicateur de fréquence, selon un premier mode de réalisation ;
- la figure 2 représente les signaux obtenus dans le dispositif de multiplication de fréquence selon le premier mode de réalisation lorsque le multiplicateur de fréquence à verrouillage par injection est verrouillé sur un multiple de la fréquence du signal d'injection qui lui est appliqué en entrée ;
- la figure 3 représente les signaux obtenus dans le dispositif de multiplication de fréquence selon le premier mode de réalisation lorsque le multiplicateur de fréquence à verrouillage par injection n'est pas verrouillé sur un multiple de la fréquence du signal d'injection qui lui est appliqué en entrée ;
- les figures 4 et 5 représentent les spectres de signaux obtenus dans un dispositif de multiplication de fréquence comprenant un dispositif de réglage du verrouillage par injection d'un multiplicateur de fréquence ;
- la figure 6 représente un exemple de réalisation d'un circuit de contrôle d'un dispositif de réglage du verrouillage par injection d'un multiplicateur de fréquence ;
- la figure 7 représente le bruit de phase du signal d'injection reçu par un filtre intégrateur d'un circuit de contrôle d'un dispositif de réglage du verrouillage par injection d'un multiplicateur de fréquence ;
- la figure 8 représente un dispositif de multiplication de fréquence comprenant un dispositif de réglage du verrouillage par injection d'un multiplicateur de fréquence, selon un deuxième mode de réalisation.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

## EXPOSÉ DÉTAILLÉ DE MODES DE RÉALISATION PARTICULIERS

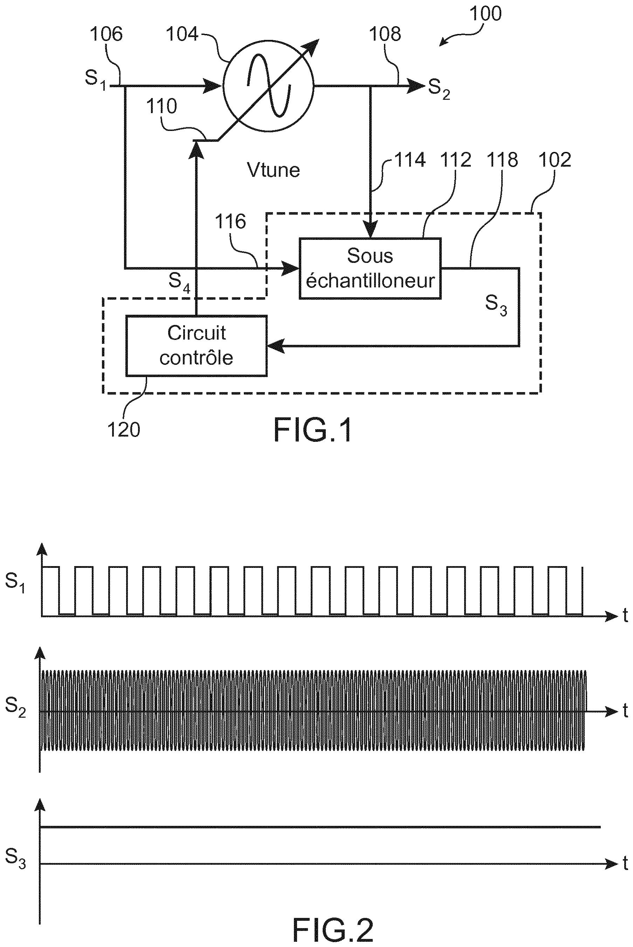

On se réfère tout d'abord à la figure 1 qui représente schématiquement un dispositif 100 de multiplication de fréquence comprenant un dispositif 102 de réglage du verrouillage par injection d'un multiplicateur de fréquence du dispositif 100, selon un premier mode de réalisation.

Dans ce premier mode de réalisation, le multiplicateur de fréquence à verrouillage par injection du dispositif 100 correspond à un oscillateur verrouillé par injection, ou ILO, 104. Cet ILO 104 correspond à un ILFM.

Une entrée 106 du dispositif 100 est reliée à une entrée d'injection de l'ILO 104. Un premier signal S1 de fréquence f1 est appliqué sur cette entrée 106. Le premier signal S1 correspond par exemple à un signal sinusoïdal ou un signal carré. Cette fréquence f1 correspond à la fréquence destinée à être multipliée par le dispositif 100.

Une sortie 108 du dispositif 100 correspond à la sortie de l'ILO 104. Un deuxième signal S2 de fréquence f2 = N.f1 est destiné à être obtenu sur cette sortie 108, avec N nombre entier supérieur à 1 lorsque l'ILO 104 est correctement verrouillé sur cette fréquence. Lorsque l'ILO 104 n'est pas correctement verrouillé sur cette fréquence qui correspond à un multiple de la fréquence f1, le signal obtenu en sortie de l'ILO 104 peut avoir un spectre complexe, centré autour de sa fréquence d'auto-oscillation, ou peut avoir un spectre simple composé uniquement de sa propre fréquence d'auto-oscillation qui ne correspond pas à un multiple de f1.

L'ILO 104 comporte également une entrée de contrôle 110 sur laquelle un signal de contrôle $V_{tune}$ est appliqué pour modifier sa fréquence d'auto-oscillation.

Le premier signal S1 correspond au signal d'injection et l'ILO 104 est destiné à être verrouillé sur une fréquence de valeur égale à un multiple de la fréquence f1. Ce premier signal S1 est par exemple généré par un générateur à quartz ou bien par une PLL, non représentés sur la figure 1.

En l'absence de signal d'injection, l'ILO 104 délivre en sortie un signal sinusoïdal d'oscillation dit « libre » et dont la fréquence est égale à sa fréquence d'auto-oscillation $f_{auto\_osc\_104}$ dont la valeur dépend de la valeur du signal de contrôle $V_{tune}$ appliqué sur son entrée de contrôle 110. Lorsque la valeur du signal de contrôle $V_{tune}$ est correctement choisie, la valeur de la fréquence $f_{auto\_osc\_104}$ est du même ordre de grandeur que celle de la fréquence f2 souhaitée ($f_{auto\_osc\_104} \approx$ f2). Lorsque l'ILO 104 reçoit sur son entrée d'injection le premier signal S1, il doit idéalement se verrouiller sur la fréquence correspondant au multiple de la fréquence f1 qui est le plus proche de la fréquence $f_{auto\_osc\_104}$. Toutefois, un réglage, ou ajustement, de la valeur du signal de contrôle $V_{tune}$ est presque toujours nécessaire pour obtenir ce verrouillage. Ce réglage de la valeur du signal de contrôle est réalisé par le dispositif 102 de réglage du verrouillage par injection de l'ILO 104.

Le dispositif 102 comporte un sous-échantillonneur 112 configuré pour réaliser un sous-échantillonnage du signal S2, qui est appliqué sur une entrée 114 du dispositif 102, à la fréquence f1 du signal S1, qui est appliqué sur une autre entrée 116 du dispositif 102. Le sous-échantillonneur 112 délivre sur une sortie 118 un signal S3 correspondant au signal S2 sous-échantillonné par le signal S1 de fréquence f1.

En variante, le sous-échantillonneur 112 peut être configuré pour réaliser un sous-échantillonnage du signal S2 à une fréquence $f_S$ égale à un multiple entier de la fréquence f1 et inférieure à la fréquence f2. Dans ce cas, le signal S3 délivré par le sous-échantillonneur 112 correspond au signal S2 sous-échantillonné à la fréquence $f_S$.

Le dispositif 102 comporte également un circuit de contrôle 120 recevant en entrée le signal S3 à partir duquel il détermine si l'ILO 104 est verrouillé ou non sur un multiple de la fréquence f1.

En effet, lorsque l'ILO 104 est verrouillé sur un multiple de la fréquence f1, la fréquence f2 du signal S2 correspond alors à ce multiple de la fréquence f1 du signal S1. Le signal S3 obtenu sur la sortie 118 du sous-échantillonneur 112 correspond dans ce cas à un signal continu. La figure 2 représente des exemples de signaux S1, S2 et S3 obtenus dans une telle configuration.

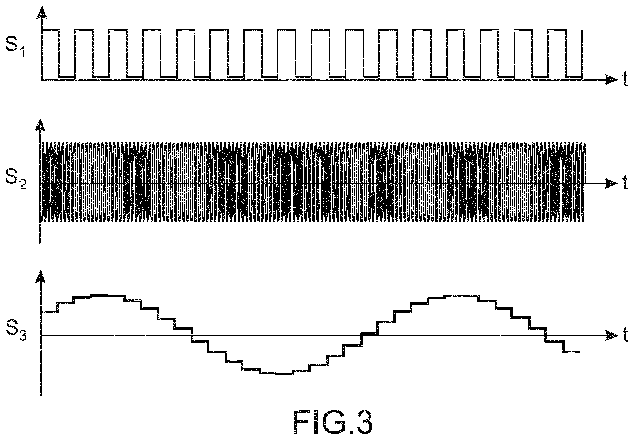

Par contre, lorsque l'ILO 104 n'est pas verrouillé sur un multiple de la fréquence f1, la fréquence f2 du signal S2 ne correspond pas à un multiple de la fréquence f1 du signal S1. Le signal S3 obtenu sur la sortie 118 du sous-échantillonneur 112 correspond dans ce cas à un signal qui varie dans le temps. Le signal S3 peut correspondre à un signal périodique dont la fréquence principale correspond à la différence entre $f_{auto\_osc\_104}$ et le multiple de f1 le plus proche de $f_{auto\_osc\_104}$, ou peut correspondre à un signal variant dans le temps avec un contenu spectral significatif au-delà de la fréquence nulle. La figure 3 représente des exemples de signaux S1, S2 et S3 obtenus dans une telle configuration. En outre, sur l'exemple de la figure 3, le signal S3 est obtenu en réalisant un sous-échantillonnage du signal S2 par un signal de fréquence $f_S$ égale à un multiple entier de la fréquence f1 et inférieure à la fréquence f2, et plus particulièrement de fréquence fS = 2.f1 sur l'exemple de la figure 3.

Ainsi, le circuit de contrôle 120 détermine, à partir du caractère continu ou variable dans le temps du signal S3, si l'ILO 104 est verrouillé ou non sur un multiple de la fréquence f1 et délivre en sortie un quatrième signal S4 dont la valeur est représentative du verrouillage ou non de l'ILO 104 sur ce multiple de la fréquence f1.

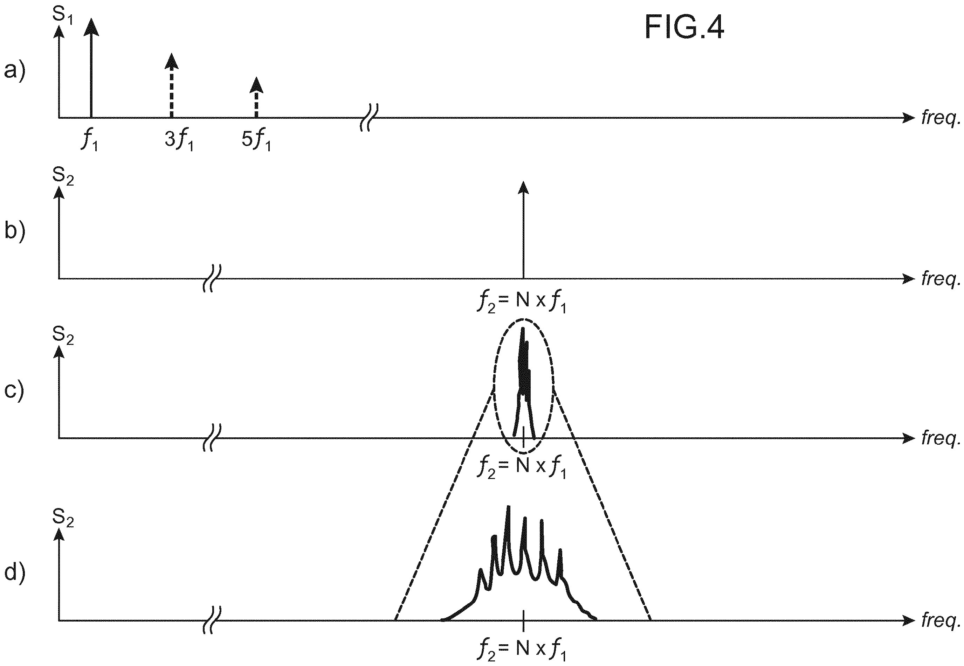

La figure 4 représente les spectres de signaux S1 et S2 obtenus dans le dispositif 100. Comme cela est visible sur le spectre référencé a) sur la figure 4, le signal S1 comporte une raie principale (de plus grande amplitude) à la fréquence f1 (fréquence fondamentale). Lorsque le signal S1 correspond à un signal sinusoïdal, cette raie principale est la seule dans tout le spectre du signal S1. Lorsque le signal S1 correspond à un signal carré, son spectre comporte également d'autres raies qui correspondent aux harmoniques se trouvant aux fréquences multiples impaires de f1 (raies représentées en traits pointillés sur la figure 4).

Le spectre référencé b) sur la figure 4 correspond à celui du signal S2 lorsque l'ILO 104 est verrouillé sur un multiple N de la fréquence f1. Le spectre de ce signal S2 correspond à une fonction $\delta$ de Dirac à la fréquence f2 = N.f1, et comporte une unique raie à la fréquence f2 (bien que non visible sur la figure 2, ce spectre est symétrique par rapport à la fréquence nulle et comporte donc également une raie à la fréquence -f2). Le spectre de ce signal S2 peut s'écrire par la relation suivante :

$$S2(f) = A_0\delta(f - f_2) + A_0\delta(f + f_2) = A_0\delta(f - N \cdot f_1) + A_0\delta(f + N \cdot f_1)$$

Le spectre référencé c) correspond à celui du signal S2 lorsque l'ILO 104 n'est pas verrouillé sur le multiple N de la fréquence f1, et le spectre référencé d) correspond à une vue agrandie autour de la fréquence f2 du spectre référencé c). Ce spectre est formé d'une multitude de raies, ou pics, autour de la fréquence d'auto-oscillation de l'ILO 104 qui est proche de la fréquence f2. Cet ensemble de raies peut être noté $S_{NL}$(f), et le spectre du signal S2 peut dans ce cas s'écrire par la relation suivante :

$$S2(f) = S_{NL}(f) * [\frac{1}{2}\delta(f - f_2) + \frac{1}{2}\delta(f + f_2)] = \frac{1}{2}S_{NL}(f - N \cdot f_1) + \frac{1}{2}S_{NL}(f + N \cdot f_1)$$

Le spectre du signal obtenu en sortie du sous-échantillonneur 112 est formé des composantes fréquentielles du signal appliqué en entrée du sous-échantillonneur 112 qui sont répétées aux multiples de la fréquence d'échantillonnage, c'est-à-dire correspond au produit de convolution du spectre du signal d'entrée du sous-échantillonneur 112 avec les fonctions $\delta$ de Dirac qui représentent le signal d'échantillonnage dans le domaine fréquentiel. Ainsi, en appelant $S_{entrée}(f)$ le spectre du signal appliqué en entrée du sous-échantillonneur 112, $f_{éch}$ la fréquence d'échantillonnage et *ci* les coefficients de Fourier du signal d'échantillonnage, avec $|c_i|=|c_{-i}|$, le spectre du signal $S_{sous-éch}$ obtenu en sortie du sous-échantillonneur 112 peut s'écrire avec la relation suivante :

$$S_{sous-éch}(f) = S_{entrée}(f) * \sum_{k=0}^{\infty} c_k\delta(f - kf_{éch}) + c_{-k}\delta(f + kf_{éch})] =$$

$$c_0 S_{entrée}(f) + c_1 S_{entrée}(f - f_{éch}) + c_{-1}S_{entrée}(f + f_{éch}) + c_2 S_{entrée}(f - 2f_{éch}) +$$

$$c_{-2}S_{entrée}(f + 2f_{éch}) + termes\ aux\ fréquences\ plus\ élevées$$

Si la largeur de bande, c'est-à-dire la largeur spectrale, du signal d'entrée est supérieure à la fréquence d'échantillonnage $f_{éch}$, les composantes spectrales du signal obtenu en sortie du sous-échantillonneur 112 aux fréquences $\pm f_{éch}$ et $\pm 2.f_{éch}$ se chevauchent et produisent du repliement, ou crénelage (« aliasing » en anglais). Par contre, si la largeur de bande du signal d'entrée est inférieure à la fréquence d'échantillonnage $f_{éch}$, cet effet de repliement ne se produit pas. En effet, si $S_{entrée}(f)$ a une bande étroite centrée autour de la fréquence f2 avec f2 > $f_{éch}$, le phénomène de repliement peut être évité si la largeur de bande de $S_{entrée}(f)$ est suffisamment étroite. Cette technique est appelée sous-échantillonnage car la fréquence d'échantillonnage $f_{éch}$ est inférieure à la fréquence centrale du signal d'entrée. Dans la configuration décrite ici, cette condition est remplie étant donné que lorsque l'ILO 104 est verrouillé sur la fréquence f2, le spectre du signal de sortie de l'ILO 104 comporte une unique raie centrée à la fréquence f2, et lorsque l'ILO 104 n'est pas verrouillé sur la fréquence f2, le spectre du signal de sortie de l'ILO 104 comporte une bande étroite centrée autour de la fréquence f2.

Lorsque l'ILO 104 est verrouillé sur la fréquence f2, le spectre du signal S3 obtenu en sortie du sous-échantillonneur 112 peut s'écrire tel que :

$$S3(f) = [A_0\delta(f - N \cdot f_1) + A_0\delta(f + N \cdot f_1)] * \sum_{k=0}^{\infty} c_k\delta(f - kf_1) + c_{-k}\delta(f + kf_1)] = c_0 2A_0 + c_1 A_0\delta(f - f_1) + c_{-1}A_0\delta(f + f_1) + termes\ aux\ fréquences\ plus\ élevées.$$

Dans ce cas, aux basses fréquences (f << f1), le spectre du signal S3 ne comporte qu'une seule composante continue, les autres composantes de ce spectre se situant à des fréquences correspondant aux multiples pairs de la fréquence f1.

Lorsque l'ILO 104 n'est pas verrouillé sur la fréquence f2, le spectre du signal S3 obtenu en sortie du sous-échantillonneur 112 peut s'écrire tel que :

$$S3(f) = [\frac{1}{2}S_{NL}(f - N \cdot f_1) + \frac{1}{2}S_{NL}(f + N \cdot f_1)] * \sum_{k=0}^{\infty} c_k\delta(f - kf_1) + c_{-k}\delta(f + kf_1)]$$

$$= c_0 S_{NL}(f) + c_1 \frac{1}{2}S_{NL}(f - f_1) + c_{-1}\frac{1}{2}S_{NL}(f + f_1)$$

$$+ termes\ aux\ fréquences\ plus\ élevées$$

Dans ce cas, aux basses fréquences (f << f1), le spectre du signal S3 comporte l'ensemble de raies noté $S_{NL}(f)$ se trouvant, dans le signal S2, autour de la fréquence f2 lorsque l'ILO 104 n'est pas verrouillé, et qui se trouve ici centré autour de la fréquence nulle. Cet ensemble se retrouve aux multiples pairs de la fréquence f1.

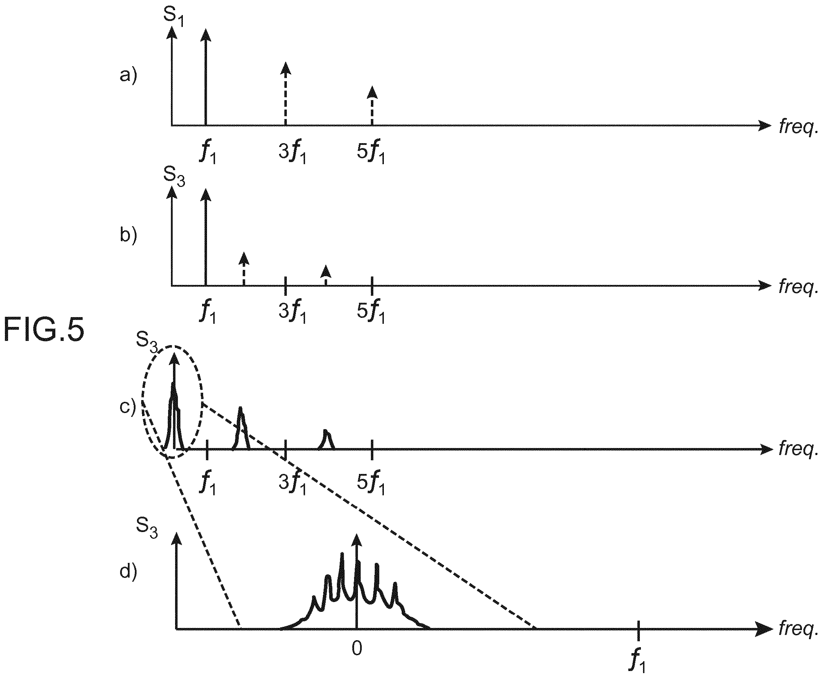

La figure 5 représente les spectres de signaux S1 et S3 dans le dispositif 100. Le signal S1, dont le spectre est référencé a), est similaire à celui dont le spectre a) est représenté sur la figure 4. Le spectre référencé b) sur la figure 5 correspond à celui du signal S3 lorsque l'ILO 104 est verrouillé sur un multiple *N* de la fréquence f1. Le spectre référencé c) correspond à celui du signal S3 lorsque l'ILO 104 n'est pas verrouillé sur le multiple N de la fréquence f1, et le spectre référencé d) correspond à une vue agrandie autour de la fréquence 0 du spectre c).

Dans le premier mode de réalisation décrit ici, le dispositif 102 est configuré pour former une boucle de rétroaction conduisant au verrouillage de l'ILO 104 sur un multiple de la fréquence f1. Pour cela, la sortie du circuit de contrôle 120 sur laquelle le signal S4 est délivré est reliée à l'entrée de contrôle 110 de l'ILO 104, et le circuit de contrôle 120 est configuré pour modifier la valeur du signal S4, qui correspond au signal de réglage appliqué en entrée de l'ILO 104, jusqu'à ce que l'ILO 104 soit verrouillé sur la valeur du multiple de f1 le plus proche de $f_{auto\_osc\_104}$.

De manière avantageuse, le dispositif 100 est utilisé lorsque la valeur du rapport f2 / f1 recherchée est supérieure à 3 et par exemple comprise entre environ 20 et 35. En effet, avec un tel facteur de multiplication, un ILO se verrouille difficilement sur la fréquence f1 du signal d'injection qui lui est appliqué en entrée. Le dispositif 102 proposé ici permet d'obtenir ce verrouillage de l'ILO 104 même avec un tel facteur de multiplication de fréquence.

A titre d'exemple, l'ILO 104 peut être réalisé comme décrit dans le document « A 50 GHz direct injection locked oscillator topology as low power frequency divider in 0.13 $\mu$m CMOS » de M. Tiebout, Solid-State Circuits Conference, 2003, ESSCIRC '03. Proceedings of the 29the European, pp. 73-76, 16-18 Sept. 2003.

A titre d'exemple, le sous-échantillonneur 112 peut correspondre à un circuit de type échantillonneur-bloqueur (« sample and hold » en anglais).

Pour détecter le verrouillage ou non de l'ILO 104 sur un multiple de la fréquence f1, le circuit de contrôle 120 peut avantageusement se baser sur le fait qu'en cas de non verrouillage, le spectre du signal S3 comporte de l'énergie au-delà de la fréquence nulle. Pour cela, le circuit de contrôle 120 peut réaliser un filtrage pour déterminer l'énergie contenue dans le signal au-delà de la fréquence 0 Hz. Cela peut être réalisé avec un filtre passe-haut, ou plus généralement avec un filtre passe-bande ayant une fréquence de coupure basse proche de 0 Hz et une fréquence de coupure haute autour de fl/2. L'utilisation d'une fréquence de coupure haute permet d'éviter que les termes de plus hautes fréquences (supérieures à cette fréquence de coupure haute) n'impactent la détermination de l'énergie du signal S3 au-delà de la fréquence nulle. La fréquence de coupure basse est choisie suffisamment basse pour couvrir une plage suffisamment grande de configurations dans lesquelles l'ILO 104 n'est pas verrouillé, même celles très proches des conditions de verrouillage de l'ILO 104.

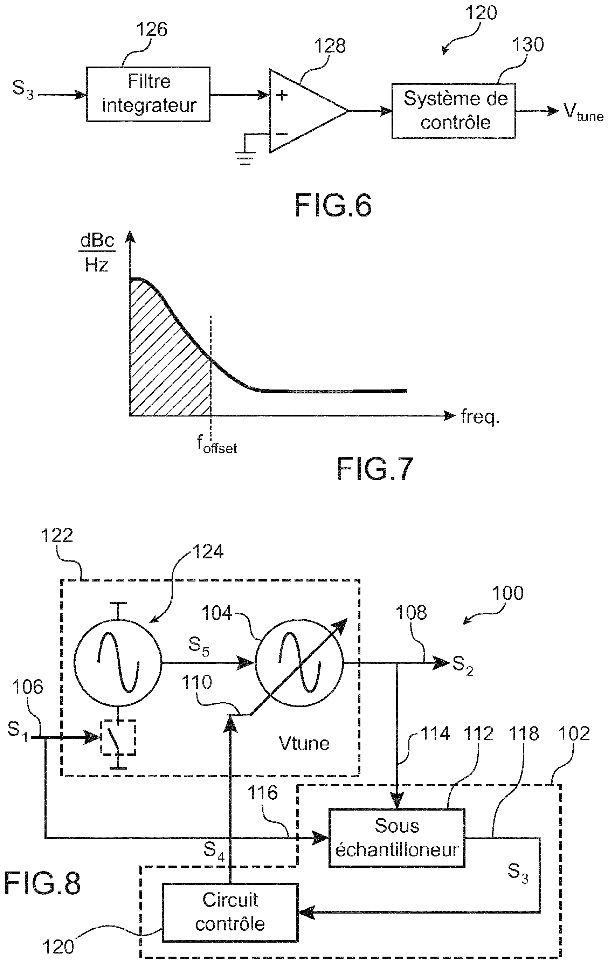

Le circuit de contrôle 120 peut être réalisé de manière analogique et/ou numérique. La figure 6 représente schématiquement un exemple de réalisation du circuit de contrôle 120.

Le circuit de contrôle 120 comporte ici un filtre intégrateur 126 recevant en entrée le signal S3 et calculant, à partir du signal S3, la quantité d'énergie entre ses fréquences de coupure basse et haute (par exemple entre 0 et fl/2). Si cette quantité d'énergie est nulle, l'ILO 104 est considéré comme étant verrouillé sur un multiple de la fréquence f1. Dans le cas contraire, l'ILO 104 est considéré comme n'étant pas verrouillé sur un multiple de la fréquence f1.

Le filtre intégrateur 126 est par exemple configuré pour réaliser un filtrage passe-haut ou passe bande du signal S3. Lorsque le filtre intégrateur 126 réalise un filtrage passe-bande du signal S3, sa fréquence de coupure haute est par exemple égale à (fl)/2. Lorsque le filtre intégrateur 126 réalise un filtrage passe-bande ou passe-haut du signal S3, sa fréquence de coupure basse peut être égale à 0 ou proche de 0. En variante, la valeur de la fréquence de coupure basse du filtre intégrateur 126 peut dépendre d'une caractéristique du signal S3, par exemple de son bruit de phase. A titre d'exemple, cette fréquence de coupure basse peut correspondre à la fréquence « offset » au-dessous de laquelle le bruit de phase du signal d'injection est majoritairement (au moins 50 %) contenu. La figure 7 représente le bruit de phase, en dBc/Hz, d'un signal correspondant par exemple au signal S3. Sur cet exemple, la fréquence de coupure basse est choisie comme étant la fréquence « offset » ($f_{offset}$ sur la figure 7) pour laquelle environ 66% du bruit de phase est contenu dans la plage de fréquence allant de 0 à $f_{offset}$ qui est par exemple égale à environ 100 kHz.

Sur l'exemple de réalisation de la figure 6, la détermination du verrouillage ou non de l'ILO 104 sur un multiple de la fréquence f1 est par exemple réalisée par un comparateur 128 comprenant une première entrée recevant le signal de sortie du filtre intégrateur 126, et une deuxième entrée sur laquelle est appliquée la valeur seuil à laquelle le signal de sortie du filtre intégrateur 126 est comparée (sur la figure 6, cette deuxième entrée est reliée à la masse).

La sortie du comparateur 128 est reliée à l'entrée d'un système de contrôle 130 qui détermine si une modification du réglage de l'ILO 104 est requise. Une telle modification peut correspondre à un décalage de la fréquence d'auto-oscillation de l'ILO 104 qui peut être réalisé en modifiant certains paramètres de contrôle de l'ILO 104 (par exemple les valeurs de capacités ou inductances variables de l'ILO 104), ou en modifiant une tension de polarisation interne ou la tension d'alimentation de l'ILO 104. Par exemple, lorsque l'ILO 104 comporte un circuit résonant et un circuit à résistance négative (par exemple un oscillateur LC ou un oscillateur Colpitts) ou oscillateur à relaxation utilisant des retards produits par des circuits RC, il est possible de faire varier une capacité variable de l'oscillateur pour régler la fréquence d'auto-oscillation de l'ILO 104. Si l'ILO 104 comporte un oscillateur en anneau formé de circuits inverseurs asymétriques ou différentiels, la fréquence d'auto-oscillation de l'ILO 104 peut être modifiée en modifiant la tension de polarisation ou d'alimentation des circuits inverseurs formant l'oscillateur en anneau.

Il est possible que le système de contrôle 130 implémente un algorithme de recherche dans lequel la fréquence d'auto-oscillation de l'ILO 104 est modifiée progressivement dans le but de minimiser le signal en sortie du filtre intégrateur 126. Un tel algorithme peut être implémenté numériquement si la sortie du comparateur 128 est utilisée comme un indicateur binaire du verrouillage de l'ILO 104. Cet algorithme peut également être implémenté analogiquement en utilisant directement la sortie du filtre intégrateur 126 et en utilisant une relation reliant ce signal de sortie à la différence entre la fréquence d'auto-oscillation et la fréquence souhaitée de l'ILO 104. Un tel système de contrôle 130 permet notamment d'obtenir un verrouillage de l'ILO 104 au centre d'une plage de fréquence de verrouillage, ce qui permet d'avoir un bruit de phase minimum.

La figure 8 qui représente schématiquement un dispositif 100 de multiplication de fréquence comprenant un dispositif 102 de réglage du verrouillage par injection d'un multiplicateur de fréquence du dispositif 100, selon un deuxième mode de réalisation.

Dans ce deuxième mode de réalisation, l'ILO 104 fait partie d'un multiplicateur de fréquence 122 incluant un générateur de signaux de type train d'oscillation répétées périodiquement, ou TORP. Ce multiplicateur 122 permet de réaliser une multiplication de fréquence qui soit stabilisée en fréquence et en bruit. Le multiplicateur de fréquence 122 comporte des éléments 124 réalisant une génération d'un signal TORP. Ces éléments 124 reçoivent en entrée le signal périodique S1 et génèrent un signal S5 correspondant à un train d'oscillations de fréquence sensiblement égale à N.fl, de durée inférieure à $T_1$ = 1/f1 et répété périodiquement à la fréquence f1, avec N nombre entier supérieur à 1. Les éléments 124 peuvent être vus comme appliquant un premier facteur de multiplication N au signal S1 car le signal S5 comporte dans son spectre une raie principale à la fréquence N.fl.

A partir de ce signal S5, l'ILO 104 génère le signal périodique S2 dont le spectre fréquentiel comporte une raie principale de fréquence f2 = (N+i).fl, avec i nombre entier, en jouant un rôle de filtre passe-bande appliqué sur le signal S5 et rejetant du spectre fréquentiel de ce signal périodique les raies autres que l'une des raies du signal S5. L'ILO 104 sert à récupérer dans le spectre du signal S5 la raie souhaitée et génère en sortie le signal périodique S2, par exemple sinusoïdale, stable de fréquence f1 = (N+i).fl. Le « i » correspond au facteur de multiplication apporté par l'ILO 104.

Des détails concernant le fonctionnement et la réalisation d'un tel multiplicateur de fréquence 122 sont donnés dans le document WO 2013/079685 A1.

Quel que soit le mode de réalisation du dispositif 100, le dispositif de réglage 102 est avantageusement utilisé pour la génération de signaux dont les fréquences appartiennent à la bande millimétrique, par exemple comprises entre environ 20 GHz et 300 GHz. Dans ce cas, la valeur de la fréquence f1 est par exemple comprise entre environ 1 GHz et 10 GHz.

Dans les deux modes de réalisation précédemment décrits, le signal S4 généré en sortie du dispositif 102 correspond à un signal de rétroaction utilisé pour ajuster le réglage de la fréquence d'oscillation libre de l'ILO 104 et donc celui de la fréquence sur laquelle l'ILO 104 se verrouille. En variante, il est possible que le signal S4 ne soit pas utilisé en tant que signal de rétroaction mais corresponde à un signal fournissant à l'utilisateur du dispositif 100 une information sur le verrouillage ou non du multiplicateur de fréquence sur un multiple de la fréquence f1. Par exemple, le circuit de contrôle 120 peut être configuré pour délivrer en sortie un signal S4 dont l'amplitude a une première valeur lorsque le multiplicateur de fréquence à verrouillage par injection est verrouillé sur une fréquence correspondant à un multiple de la fréquence f1, et a une deuxième valeur, différente de la première valeur, lorsque le multiplicateur de fréquence à verrouillage par injection n'est pas verrouillé sur une fréquence correspondant à un multiple de la fréquence f1.

**Revendications**

1. Dispositif (102) de réglage configuré pour régler le verrouillage d'un multiplicateur de fréquence à verrouillage par injection (104, 122), comprenant au moins :

   - une première entrée (116) configurée pour recevoir un premier signal de fréquence f1 destiné à être appliqué en entrée du multiplicateur de fréquence à verrouillage par injection (104, 122), et une deuxième entrée (114) configurée pour recevoir un deuxième signal de fréquence f2 destiné à être délivré en sortie du multiplicateur de fréquence à verrouillage par injection (104, 122) ;
   - un sous-échantillonneur (112) configuré pour réaliser un sous-échantillonnage du deuxième signal par le premier signal ou par un autre signal de fréquence $f_S$ égale à un multiple entier de la fréquence f1 et inférieure à la fréquence f2 ;
   - un circuit de contrôle (120) configuré pour :

     • recevoir en entrée un troisième signal obtenu en sortie du sous-échantillonneur (112) et correspondant au deuxième signal sous-échantillonné par le premier signal ou par le signal de fréquence $f_S$, puis
     • déterminer que le multiplicateur de fréquence à verrouillage par injection (104, 122) est verrouillé sur une fréquence égale à un multiple de la fréquence f1 lorsque le troisième signal est continu et que le multiplicateur de fréquence à verrouillage par injection (104, 122) n'est pas verrouillé sur une fréquence égale à un multiple de la fréquence f1 lorsque le troisième signal varie dans le temps, puis
     • délivrer en sortie un quatrième signal dont la valeur est représentative du verrouillage ou non du multiplicateur de fréquence à verrouillage par injection (104, 122) sur une fréquence correspondant à un multiple de la fréquence f1 ;

et dans lequel le circuit de contrôle (120) comporte un filtre intégrateur (126) configuré pour réaliser un filtrage passe-haut ou passe-bande du troisième signal, le multiplicateur de fréquence à verrouillage par injection (104, 122) étant considéré comme verrouillé sur une fréquence correspondant à un multiple de la fréquence f1 lorsque le signal obtenu par ce filtrage passe-haut ou passe-bande est sensiblement nul.

2.  Dispositif (102) selon la revendication 1, dans lequel la sortie du circuit de contrôle (120) est configurée pour être reliée à une entrée de contrôle (110) du multiplicateur de fréquence à verrouillage par injection (104, 122), le dispositif (102) étant configuré pour former une boucle de rétroaction permettant le verrouillage du multiplicateur de fréquence à verrouillage par injection (104, 122) sur une fréquence correspondant à un multiple de la fréquence f1.

3.  Dispositif (102) selon l'une des revendications précédentes, dans lequel le filtre intégrateur (126) est configuré pour réaliser un filtrage passe-bande du troisième signal avec une fréquence de coupure haute égale à environ (fl)/2.

4.  Dispositif (102) selon l'une des revendications précédentes, dans lequel le circuit de contrôle (120) comporte en outre un comparateur (128) configuré pour comparer un signal de sortie du filtre intégrateur (126) avec une valeur seuil, et un système de contrôle (130) configuré pour modifier ou non au moins un paramètre du multiplicateur de fréquence à verrouillage par injection en fonction d'une valeur d'un signal de sortie du comparateur (128).

5.  Dispositif (100) de multiplication de fréquence, comprenant au moins :

    - un multiplicateur de fréquence à verrouillage par injection (104, 122) ;
    - un dispositif (102) de réglage selon l'une des revendications précédentes, dont la deuxième entrée (114) est couplée à une sortie du multiplicateur de fréquence à verrouillage par injection (104, 122).

6.  Dispositif (100) selon la revendication 5, dans lequel la valeur du rapport f2 / f1 est comprise entre environ 20 et 35.

7.  Dispositif (100) selon l'une des revendications 5 ou 6, dans lequel le multiplicateur de fréquence à verrouillage par injection (104, 122) comporte au moins un oscillateur verrouillé par injection, ILO (104).

8.  Dispositif (100) selon la revendication 7, dans lequel le multiplicateur de fréquence à verrouillage par injection (122) comporte en outre un générateur (124) de train d'oscillations répétées périodiquement configuré pour recevoir en entrée le premier signal et pour générer en sortie un cinquième signal correspondant à un train d'oscillations de fréquence sensiblement égale à N.fl, de durée inférieure à T1 = 1/f1 et répété périodiquement à la fréquence f1, avec N nombre entier supérieur à 1, et dont la sortie est couplée à l'entrée de l'ILO (104).

9.  Dispositif (100) selon la revendication 7, dans lequel une entrée d'injection de l'ILO (104) est configurée pour recevoir le premier signal.

10. Dispositif (100) selon l'une des revendications 7 à 9, dans lequel :

    - une entrée de contrôle de l'ILO (104) est couplée à la sortie du circuit de contrôle (120) ;
    - le circuit de contrôle (120) est configuré pour modifier la valeur du quatrième signal jusqu'à ce que le multiplicateur de fréquence à verrouillage par injection (104, 122) soit verrouillé sur une fréquence correspondant à un multiple de la fréquence f1.

11. Procédé de réglage du verrouillage d'un multiplicateur de fréquence à verrouillage par injection (104, 122), comprenant au moins :

    - génération, par le multiplicateur de fréquence à verrouillage par injection (104, 122) et à partir d'un premier signal de fréquence f1, d'un deuxième signal de fréquence f2 ;
    - génération d'un troisième signal correspondant au deuxième signal sous-échantillonné par le premier signal ou par un autre signal de fréquence $f_S$ égale à un multiple entier de la fréquence f1 et inférieure à la fréquence f2;
    - filtrage passe-haut ou passe-bande du troisième signal ;
    - détermination que le multiplicateur de fréquence à verrouillage par injection (104, 122) est verrouillé sur une fréquence égale à un multiple de la fréquence f1 lorsque le signal obtenu par ce filtrage passe-haut ou passe-bande est sensiblement nul ;
- génération d'un quatrième signal dont la valeur est représentative du verrouillage ou non du multiplicateur de fréquence à verrouillage par injection (104, 122) sur une fréquence correspondant à un multiple de la fréquence f1.

**Patentansprüche**

1. Einstellvorrichtung (102), die dazu ausgelegt ist, die Verriegelung eines injektionsverriegelten Frequenzmultiplikators (104, 122) einzustellen, zumindest enthaltend:

   - einen ersten Eingang (116), der dazu ausgelegt ist, ein erstes Signal mit der Frequenz f1 zu empfangen, das an den Eingang des injektionsverriegelten Frequenzmultiplikators (104, 122) angelegt werden soll, und einen zweiten Eingang (114), der dazu ausgelegt ist, ein zweites Signal mit der Frequenz f2 zu empfangen, das an dem Ausgang des injektionsverriegelten Frequenzmultiplikators (104, 122) ausgegeben werden soll;
   - einen Unterabtaster (112), der dazu ausgelegt ist, eine Unterabtastung des zweiten Signals durch das erste Signal oder durch ein anderes Signal mit einer Frequenz $f_S$, die gleich einem ganzzahligen Vielfachen der Frequenz f1 und kleiner als die Frequenz f2 ist, durchzuführen;
   - eine Steuerschaltung (120), die dazu ausgelegt ist,

     • am Eingang ein drittes Signal zu empfangen, das am Ausgang des Unterabtasters (112) erhalten wird und dem zweiten Signal entspricht, das durch das erste Signal oder durch das Signal mit der Frequenz $f_S$ unterabgetastet wird, dann
     • zu bestimmen, dass der injektionsverriegelte Frequenzmultiplikator (104, 122) auf eine Frequenz gleich einem Vielfachen der Frequenz f1 verriegelt wird, wenn das dritte Signal kontinuierlich ist, und dass der injektionsverriegelte Frequenzmultiplikator (104, 122) nicht auf eine Frequenz gleich einem Vielfachen der Frequenz f1 verriegelt wird, wenn das dritte Signal zeitlich variiert, dann
     • am Ausgang ein viertes Signal auszugeben, dessen Wert repräsentativ dafür ist, ob der injektionsverriegelte Frequenzmultiplikator (104, 122) auf eine Frequenz, die einem Vielfachen der Frequenz f1 entspricht, verriegelt wird oder nicht;

   wobei die Steuerschaltung (120) ein integrierendes Filter (126) aufweist, das dazu ausgelegt ist, eine Hochpass- oder Bandpassfilterung des dritten Signals durchzuführen, wobei der injektionsverriegelte Frequenzmultiplikator (104, 122) als auf eine einem Vielfachen der Frequenz f1 entsprechende Frequenz verriegelt betrachtet wird, wenn das durch eine solche Hochpass- oder Bandpassfilterung erhaltene Signal im Wesentlichen Null ist.

2. Vorrichtung (102) nach Anspruch 1, wobei der Ausgang der Steuerschaltung (120) dazu ausgelegt ist, mit einem Steuereingang (110) des injektionsverriegelten Frequenzmultiplikators (104, 122) verbunden zu werden, wobei die Vorrichtung (102) dazu ausgelegt ist, eine Rückkopplungsschleife zu bilden, die es ermöglicht, den injektionsverriegelten Frequenzmultiplikator (104, 122) auf eine Frequenz zu verriegeln, die einem Vielfachen der Frequenz f1 entspricht.

3. Vorrichtung (102) nach einem der vorangehenden Ansprüche, wobei das integrierende Filter (126) dazu ausgelegt ist, eine Bandpassfilterung des dritten Signals mit einer hohen Grenzfrequenz durchzuführen, die etwa gleich (f1)/2 ist.

4. Vorrichtung (102) nach einem der vorangehenden Ansprüche, wobei die Steuerschaltung (120) ferner einen Komparator (128) enthält, der dazu ausgelegt ist, ein Ausgangssignal des integrierenden Filters (126) mit einem Schwellenwert zu vergleichen, sowie ein Steuersystem (130), das dazu ausgelegt ist, zumindest einen Parameter des injektionsverriegelten Frequenzmultiplikators in Abhängigkeit von einem Wert eines Ausgangssignals des Komparators (128) zu modifizieren oder nicht.

5. Frequenzmultiplikationsvorrichtung (100), zumindest enthaltend:

   - einen injektionsverriegelten Frequenzmultiplikator (104, 122);
   - eine Einstellvorrichtung (102) nach einem der vorangehenden Ansprüche, deren zweiter Eingang (114) mit einem Ausgang des injektionsverriegelten Frequenzmultiplikators (104, 122) gekoppelt ist.

6. Vorrichtung (100) nach Anspruch 5, wobei der Wert des Verhältnisses f2 / f1 zwischen etwa 20 und 35 liegt.

7. Vorrichtung (100) nach einem der Ansprüche 5 oder 6, wobei der injektionsverriegelte Frequenzmultiplikator (104, 122) zumindest einen injektionsverriegelten Oszillator, ILO (104), enthält.

8. Vorrichtung (100) nach Anspruch 7, wobei der injektionsverriegelte Frequenzmultiplikator (122) ferner einen Schwingungszugerreger (124) für periodisch wiederholte Schwingungen enthält, der dazu ausgelegt ist, am Eingang das erste Signal zu empfangen und am Ausgang ein fünftes Signal zu erzeugen, das einem Schwingungszug entspricht, der eine Frequenz im Wesentlichen gleich N.f1, eine Dauer von weniger als T1 = 1/f1 hat und periodisch mit der Frequenz f1 wiederholt wird, wobei N eine ganze Zahl größer als 1 ist, und dessen Ausgang mit dem Eingang des ILO (104) gekoppelt ist.

9. Vorrichtung (100) nach Anspruch 7, wobei ein Injektionseingang des ILO (104) dazu ausgelegt ist, das erste Signal zu empfangen.

10. Vorrichtung (100) nach einem der Ansprüche 7 bis 9, wobei

   - ein Steuereingang des ILO (104) mit dem Ausgang der Steuerschaltung (120) gekoppelt ist;
   - die Steuerschaltung (120) dazu ausgelegt ist, den Wert des vierten Signals solange zu modifizieren, bis der injektionsverriegelte Frequenzmultiplikator (104, 122) auf eine Frequenz verriegelt wird, die einem Vielfachen der Frequenz f1 entspricht.

11. Verfahren zum Einstellen der Verriegelung eines injektionsverriegelten Frequenzmultiplikators (104, 122), zumindest umfassend:

   - Erzeugen eines zweites Signals mit der Frequenz f2 durch den injektionsverriegelten Frequenzmultiplikator (104, 122) ausgehend von einem ersten Signal mit der Frequenz f1;
   - Erzeugen eines dritten Signals, das dem zweiten Signal entspricht, das durch das erste Signal oder durch ein anderes Signal mit einer Frequenz $f_S$ unterabgetastet wird, die gleich einem ganzzahligen Vielfachen der Frequenz f1 und kleiner als die Frequenz f2 ist;
   - Hochpass- oder Bandpassfilterung des dritten Signals;
   - Bestimmen, dass der injektionsverriegelte Frequenzmultiplikator (104, 122) auf eine Frequenz verriegelt wird, die gleich einem Vielfachen der Frequenz f1 ist, wenn das durch eine solche Hochpass- oder Bandpassfilterung erhaltene Signal im Wesentlichen Null ist;
   - Erzeugen eines vierten Signals, dessen Wert repräsentativ dafür ist, ob der injektionsverriegelte Frequenzmultiplikator (104, 122) auf eine Frequenz, die einem Vielfachen der Frequenz f1 entspricht, verriegelt wird oder nicht.

**Claims**

1. Device (102) for adjusting the locking of an injection locked frequency multiplier (104, 122), including at least:

   - a first input (116) configured for receiving a first signal of frequency f1 intended to be applied as input of the injection locked frequency multiplier (104, 122), and a second input (114) configured for receiving a second signal of frequency f2 intended to be outputted by the injection locked frequency multiplier (104, 122);
   - a sub-sampler (112) configured for carrying out a sub-sampling of the second signal by the first signal or by another signal of frequency $f_S$ equal to an integer multiple of the frequency f1 and less than the frequency f2;
   - a control circuit (120) configured for:

      • receiving as input a third signal obtained as output of the sub-sampler (112) and corresponding to the second signal sub-sampled by the first signal or by the signal of frequency $f_S$, then
      • determining that the injection locked frequency multiplier (104, 122) is locked on a frequency equal to a multiple of the frequency f1 when the third signal is continuous and when the injection locked frequency multiplier (104, 122) is not locked on a frequency equal to a multiple of the frequency f1 when the third signal varies over time, then
      • outputting a fourth signal the value of which is representative of the locking or not of the injection locked frequency multiplier (104, 122) on a frequency corresponding to a multiple of the frequency f1;

and wherein the control circuit (120) comprises an integrator filter (126) configured for carrying out a high-pass or pass-band filtering of the third signal, the injection locked frequency multiplier (104, 122) being considered as locked on a frequency corresponding to a multiple of the frequency f1 when the signal obtained by said high-pass or pass-band filtering is substantially zero.

2. Device (102) according to claim 1, wherein the output of the control circuit (120) is configured for being connected to a control input (110) of the injection locked frequency multiplier (104, 122), the device (102) being configured for forming a feedback loop for the locking of the injection locked frequency multiplier (104, 122) on a frequency corresponding to a multiple of the frequency f1.

3. Device (102) according to one of previous claims, wherein the integrator filter (126) is configured for carrying out a pass-band filtering of the third signal with a high cut-off frequency equal to approximately (f1)/2.

4. Device (102) according to one of previous claims, wherein the control circuit (120) further comprises a comparator (128) configured for comparing an output signal of the integrator filter (126) with a threshold value, and a control system (130) configured for changing or not at least one parameter of the injection locked frequency multiplier according to a value of an output signal of the comparator (128).

5. Frequency multiplication device (100), including at least:

   - an injection locked frequency multiplier (104, 122);
   - an adjustment device (102) according to one of previous claims, the second input (114) of which is coupled to an output of the injection locked frequency multiplier (104, 122).

6. Device (100) according to claim 5, wherein the value of the f2/f1 ratio is between approximately 20 and 35.

7. Device (100) according to one of claims 5 or 6, wherein the injection locked frequency multiplier (104, 122) comprises at least one injection-locked oscillator, ILO (104).

8. Device (100) according to claim 7, wherein the injection locked frequency multiplier (122) further comprises a periodically repeated oscillation train generator (124) configured for receiving as input the first signal and for generating as output a fifth signal corresponding to oscillations train of frequency substantially equal to N.fl, of duration less than T1 = 1/f1 and repeated periodically at the frequency f1, with N integer number greater than 1, and the output of which is coupled to the input of the ILO (104).

9. Device (100) according to claim 7, wherein an injection input of the ILO (104) is configured for receiving the first signal.

10. Device (100) according to one of claims 7 to 9, wherein:

    - a control input of the ILO (104) is coupled to the output of the control circuit (120);
    - the control circuit (120) is configured for changing the value of the fourth signal until the injection locked frequency multiplier (104, 122) is locked on a frequency corresponding to a multiple of the frequency f1.

11. Method for adjusting the locking of an injection locked frequency multiplier (104, 122), including at least:

    - generation, by the injection locked frequency multiplier (104, 122) and from a first signal of frequency f1, of a second signal of frequency f2;
    - generation of a third signal corresponding to the second signal sub-sampled by the first signal or by another signal of frequency $f_S$ equal to an integer multiple of the frequency f1 and less than the frequency f2;
    - high-pass or pass-band filtering of the third signal;
    - determination that the injection locked frequency multiplier (104, 122) is locked on a frequency equal to a multiple of the frequency f1 when the signal obtained by said high-pass or pass-band filtering is substantially zero;
    - generation of a fourth signal the value of which is representative of the locking or not of the injection locked frequency multiplier (104, 122) on a frequency corresponding to a multiple of the frequency f1.

FIG.1

FIG.2

FIG.3

FIG.4

EP 3 624 343 B1

FIG.5

FIG.6

FIG.7

FIG.8

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2013079685 A1

**Littérature non-brevet citée dans la description**

- **DE C. JANY et al.** A programmable Frequency Multiplier-by-29 Architecture for Millimeter Wave Applications. *IEEE Journal of Solid-State Circuits,* Juillet 2015, 1-11
- **DE W. DENG et al.** A Sub-Harmonic Injection-Locked Quadrature Frequency Synthesizer with Frequency Calibration Scheme for Millimeter-Wave TDD Transceivers. *IEEE J. Solid-State Circuits,* Juillet 2013, vol. 48 (7), 1710-1720
- **DONGSEOK SHIN et al.** A Mixed-Mode Injection Frequency-Locked Loop for Self-Calibration of Injection Locking Range and Phase Noise in $0.13\mu m$ CMOS. *ISSCC,* 2016, 50-51

- **SEYEON YOO et al.** A Low-Integrated-Phase-Noise 27-30-GHz Injection-Locked Frequency Multiplier With an Ultra-Low-Power Frequency-Tracking Loop for mm-Wave-Band 5G Transceivers. *IEEE Journal of Solid-StateE Circuits,* Février 2018, vol. 53 (2
- A $370\mu W$ Ring VCO Based Injection-Locked Frequency Synthesizer for GPS Receiver. **CHENG-GANG YAN et al.** 2018 3RD INTERNATIONAL CONFERENCE ON COMPUTER AND COMMUNICATION SYSTEMS (ICCCS). IEEE, 27 Avril 2018, 387-391
- **M. TIEBOUT.** A 50 GHz direct injection locked oscillator topology as low power frequency divider in 0.13 $\mu m$ CMOS. *Solid-State Circuits Conference, 2003, ESSCIRC '03. Proceedings of the 29the European,* 16 Septembre 2003, 73-76